Europäisches Patentamt

European Patent Office

Office européen des brevets

(11) Veröffentlichungsnummer: **0 198 196 B1**

(12) # EUROPÄISCHE PATENTSCHRIFT

(45) Veröffentlichungstag der Patentschrift: **03.02.93**

(51) Int. Cl.5: **H01L 31/06**, H01L 31/02

(21) Anmeldenummer: **86102896.7**

(22) Anmeldetag: **05.03.86**

(54) **Solarzelle mit einem aus amorphen Silizium bestehenden Halbleiterkörper der Schichtenfolge p-SiC/i/n.**

(30) Priorität: **11.04.85 DE 3513012**

(43) Veröffentlichungstag der Anmeldung:
**22.10.86 Patentblatt 86/43**

(45) Bekanntmachung des Hinweises auf die
Patenterteilung:
**03.02.93 Patentblatt 93/05**

(84) Benannte Vertragsstaaten:
**DE FR GB IT**

(56) Entgegenhaltungen:

**PATENT ABSTRACTS OF JAPAN, Band 8, Nr. 256 (E-280)[1693], 22. November 1984; & JP-A-59 127 895 (FUJIKURA DENSEN K.K.) 23-07-1984**

**PATENT ABSTRACTS OF JAPAN, Band 8, Nr. 250 (E-279)[1687], 16. November 1984; & JP-A-59 126 693 (FUJIKURA DENSEN K.K.) 21-07-1984**

**APPLIED PHYSICS LETTERS, Band 28, Nr. 1, 1. Januar 1976, Seiten 44-46; W.-T. TSANG et al.: "Profile and groove-depth control in GaAs diffraction gratings fabricated by pre-ferential chemical etching in H2SO4-H2O2-H2O system"**

**JOURNAL OF LIGHTWAVE TECHNOLOGY, Band LT-2, Nr. 4, August 1984, Seiten 363-369, New York, US; M. KITAMURA et al.: "High-performance single-longitudinal-mode operation of InGaAsP/InP DFB-DC-PBH LD'S"**

(73) Patentinhaber: **SIEMENS AKTIENGESELL-SCHAFT**
**Wittelsbacherplatz 2**
**W-8000 München 2(DE)**

(72) Erfinder: **Möller, Matthias, Dipl.-Phys.**
**Plievierpark 12**
**W-8000 München 83(DE)**

## Beschreibung

Die Erfindung betrifft eine amorphe Silizium-Solarzelle mit einer aus vorzugsweise dotiertem Zinnoxid bestehenden transparenten Grundelektrode und einem Halbleiterkörper, der zwischen einer der Grundelektrode (2) benachbarten a-SiC p-Zone und einer a-Si n-Zone eine intrinsische (i) a-Si-Schicht enthält, welche eine Phosphordotierung aufweist.

Aus J. Appl. Phys. 54 (11) Seiten 6705 bis 6707 als auch aus Appl. Phys. Letters 44 (11) Seiten 1092 bis 1094 sind Solarzellen bekannt, welche ein Bordotierungsprofil in der i-Schicht aufweisen. Dadurch wird erreicht, daß ein hoher Wirkungsgrad bis zu 9,45 % und gute Füllfaktoren von 0,72 erzielt werden. Die Zellen werden auf Glassubstraten erzeugt und das Licht wird von der p-Seite her eingestrahlt.

Eine Solarzelle, bei der das Licht von der n-Seite her eingestrahlt wird, und welche zur Verbesserung der Stabilität in Richtung i/n-Übergang ein linear abnehmendes Bordotierungsprofil aufweist, wird in der deutschen Pat. Anm. DE-P-34 39 088.5 vorgeschlagen.

Dünnschichtsolarzellen aus amorphem Silizium (a-Si) mit der Schichtenfolge p-SiC/i/n zeigen generell mehr oder weniger ausgeprägt den sogenannten Staebler-Wronski-Effekt. Durch diesen Effekt kann bei Beleuchtung, vor allen Dingen, wenn die Zelle offen betrieben wird, also die Leerlaufspannung anliegt, eine reversible Abnahme des Wirkungsgrades, zum Beispiel um ca. 18 % bei einer Beleuchtung von 100 mW/cm$^2$ mit einer Zeitdauer von 16 Stunden erfolgen. Reversibel bedeutet hier, daß durch eine Temperung der Anordnung bei zum Beispiel 180° C nach 30 Minuten die Ausgangswerte des Wirkungsgrades wieder erreicht werden. Obwohl die Abnahme des Wirkungsgrades sich mit der Zeit verringert, sind derartige Zellen für den technischen Einsatz nur bedingt brauchbar.

In dem Technical Digest of the International PVSEC-1, Kobe, Japan, Seiten 217 - 220 wird eine Solarzelle der eingangs genannten Art beschrieben, welche durch einen Phosphorpegel von ca. 0.5 ppm, der konstant über die genannte i-Schicht verläuft, eine geringere Lichtalterung erreicht. Die dabei erzielte Stabilitätsverbesserung ist aber aufgrund der niedrigen Pegelkonzentrationen zu niedrig. Die Einstellung höherer Pegelwerte würde zu einer starken Wirkungsgraderniedrigung führen.

Aufgabe der Erfindung ist es, die eben beschriebene Lichtalterung zu verhindern und eine stabile, den Staebler-Wronski-Effekt nicht aufweisende Solarzelle mit hohem Wirkungsgrad zu schaffen.

Diese Aufgabe wird durch eine Solarzelle der eingangs genannten Art dadurch gelöst, daß die intrinsische Schicht ein in Richtung i/n-Übergang ansteigendes Phosphordotierungsprofil aufweist.

Es liegt im Rahmen der Erfindung, daß die Phosphorkonzentration am p-SiC/i-Übergang 0 ppm im amorphen Silizium (a-Si) beträgt und bis auf werte zwischen 3 und 10 ppm am i/n-Übergang ansteigt. Ein entsprechender Phosphorkonzentrationsgradient stellt sich im amorphen Silizium ein. Die Verschleppung von Bor in die i-Schicht aus der zugrundeliegenden p-Schicht wird durch die Phosphordotierung überkompensiert. Im Reaktionsgas wird der Phosphoranteil zum Beispiel linear ansteigend bis auf 6 ppm Phosphin (PH$_3$) in bezug auf das Reaktionsgas Silan (SiH$_4$) eingestellt.

Weitere Ausgestaltungen der Erfindung ergeben sich aus den Unteransprüchen.

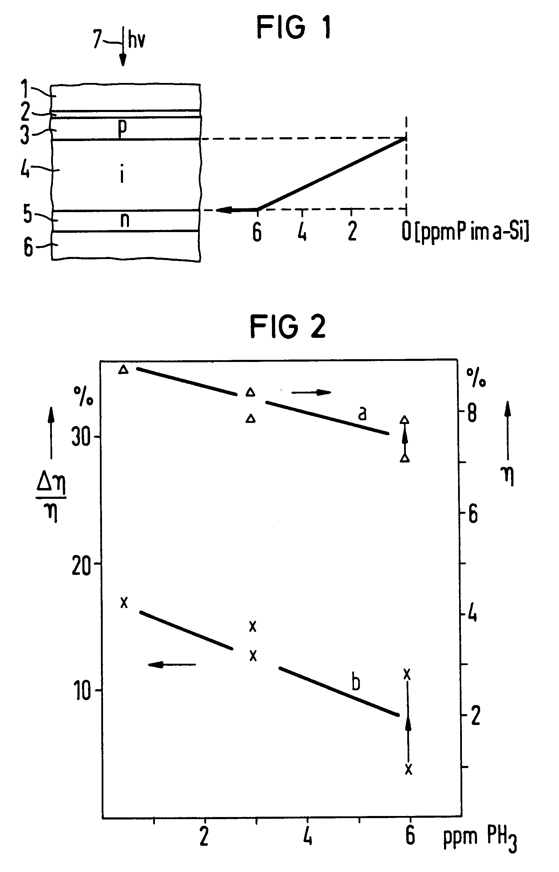

Die Erfindung wird im folgenden anhand der Figuren 1 und 2 noch näher erläutert. Dabei zeigt

die Figur 1 schematisch den Aufbau der Solarzelle mit nebenstehendem Phosphordotierungsprofil und

die Figur 2 in Kurve b die relative Abnahme des Wirkungsgrades ($\frac{\Delta\eta}{\eta}$) in Prozent (linke Ordinate) durch eine 16 stündige 100 mW/cm$^2$-Beleuchtung ohne Lastwiderstand (Staebler-Wronski-Effekt) in Abhängigkeit von der Phosphorkonzentration; die Abszisse zeigt den Endwert am i-n-Übergang von Phosphin im Silan; die Kurve a zeigt den Wirkungsgrad $\eta$ vor der Beleuchtung (rechte Ordinate).

In Figur 1 gelten folgende Bezugszeichen:

1 = Substratkörper aus Glas, welcher die zu beleuchtende Seite kennzeichnet,

2 = leitfähige, mit Fluor dotierte Zinnoxidschicht (Antireflexschicht, 500 nm, 20 Ω □ )

3 = amorphe Siliziumschicht, dotiert mit Bor und Kohlenstoff (C) (10 nm),

4 = amorphe Siliziumschicht, intrinsisch mit Phosphorprofil (500 nm),

5 = amorphe Siliziumschicht, n-dotiert (15 nm),

6 = Silber-Schicht (als reflektierende Dekkelelektrode (0,2 μm) zur Erhöhung der Lichtreflexion.

7 = Richtung der einfallenden Strahlen (hv).

Wie aus der Figur 2 zu entnehmen ist, zeigt die Lichtalterung von Zellen ohne Lastwiderstand und mit dem (linearen) Phosphordotierungsprofil in der intrinsische Schicht nur Änderungen des Wirkungsgrades $\eta$ von 4 % bis 10 %, während Zellen ohne Phosphorprofil 18 % Wirkungsgradänderung zeigen.

Der Wirkungsgrad ist zwar bei 6 ppm-Phosphin-Endkonzentration um ca. 10 % geringer, die Stabilität der erfindungsgemäßen Zellen ist im Vergleich zu den bekannten Anordnungen aber wesentlich besser.

**Patentansprüche**

1. Amorphe Silizium-Solarzellen mit einer aus vorzugsweise dotiertem Zinnoxid-bestehenden transparenten Grundelektrode (2) und einem Halbleiterkörper (3, 4, 5), der zwischen einer der Grundelektrode (2) benachbarten a-SiC p-Zone (3) und einer a-Si n-Zone (5) eine intrinsische (i)a-Si-Schicht (4) enthält, welche eine Phosphordotierung aufweist, **dadurch gekennzeichnet**, daß die intrinsische Schicht (4) ein in Richtung i/n-Übergang ansteigendes Phosphordotierungsprofil aufweist.

2. Solarzelle nach Anspruch 1, **dadurch gekennzeichnet**, daß die Phosphorkonzentration am p-SiC/i-Übergang 0 ppm im amorphen Silizium (4) beträgt und bis auf Werte zwischen 3 und 10 ppm am i/n-Übergang ansteigt.

3. Solarzelle nach Anspruch 1 und/oder 2, **dadurch gekennzeichnet**, daß die Schichtdicke der i-Schicht (4) auf 0,2 bis 1,0 $\mu$m eingestellt wird.

4. Solarzelle nach mindestens einem der Ansprüche 1 bis 3, **dadurch gekennzeichnet**, daß die Grundelektrode (2) aus mit Fluor dotiertem Zinnoxid besteht.

**Claims**

1. Amorphous silicon solar cells having a transparent base electrode (2) comprising preferably doped stannic oxide and a semiconductor body (3, 4, 5), which includes, between a p-type a-SiC zone (3) adjacent to the base electrode (2) and an n-type a-Si zone (5), an intrinsic (i) a-Si layer (4) which exhibits a phosphorus doping, characterised in that the intrinsic layer (4) exhibits a phosphorus doping profile which increases in the direction of the i/n junction.

2. Solar cell according to Claim 1, characterised in that the phosphorus concentration at the p-SiC/i junction is 0 ppm in the amorphous silicon (4) and increases to values between 3 and 10 ppm at the i/n junction.

3. Solar cell according to Claim 1 and/or 2, characterised in that the layer thickness of the i-layer (4) is set to a value within the range from 0.2 to 1.0 $\mu$m.

4. Solar cell according to at least one of Claims 1 to 3, characterised in that the base electrode (2) comprises stannic oxide doped with fluorine.

**Revendications**

1. Pile solaire au silicium amorphe comportant une électrode de base transparente (2) constituée par de l'oxyde d'étain de préférence dopé, et un corps semiconducteur (3, 4, 5), qui comporte, entre une zone de a-SiC de type p (3) voisine de l'électrode de base (2) et une zone de a-Si de type n (5), une couche de a-Si (4) intrinsèque (i), qui possède un dopage au phosphore, caractérisée par le fait que la couche intrinsèque (4) possède un profil de dopage au phosphore, qui augmente en direction de la jonction i/n.

2. Pile solaire suivant la revendication 1, caractérisée par le fait que la concentration de phosphore au niveau de la jonction p-SiC/i est égale à 0 ppm dans le silicium amorphe (4) et augmente jusqu'à des valeurs comprises entre 3 ppm au niveau de la jonction i/n.

3. Pile solaire suivant la revendication 1 et/ou 2, caractérisée par le fait que l'épaisseur de la couche de type i (4) est réglée à une valeur comprise entre 0,2 et 1,0 $\mu$m.

4. Pile solaire suivant au moins l'une des revendications 1 à 3, caractérisée par le fait que l'électrode de base (2) est constituée par de l'oxyde d'étain dopé par du fluor.

# FIG 1

# FIG 2